# EUROPÄISCHE PATENTSCHRIFT

(11) **EP 1 226 594 B1**
(45) Veröffentlichungstag und Bekanntmachung des Hinweises auf die Patenterteilung: **15.02.2006**
(21) Anmeldenummer: 00975888.9
(22) Anmeldetag: 20.10.2000
(51) Int. Cl.: H01F 7/18, H03F 1/34, G05F 1/575

(54) **ELEKTRISCHE SCHALTUNGSANORDNUNG ZUR UMFORMUNG EINER EINGANGSSPANNUNG**
ELECTRICAL CIRCUIT ARRANGEMENT FOR CONVERTING AN INPUT VOLTAGE
ENSEMBLE CIRCUIT ELECTRIQUE SERVANT A CONVERTIR UNE TENSION D'ENTREE

(30) Priorität: 28.10.1999 DE 19951944
(43) Veröffentlichungstag der Anmeldung: 31.07.2002
(73) Patentinhaber: Bosch Rexroth AG, 97816 Lohr am Main (DE)
(72) Erfinder: KISON, Thomas, 97816 Lohr am Main (DE); MEISSELBACH, Alexander, 97794 Rieneck (DE)
(86) Internationale Anmeldenummer: PCT/EP2000/010326
(87) Internationale Veröffentlichungsnummer: WO 2001/031663

(56) Entgegenhaltungen:
- EP-A- 0 779 702
- DE-A- 19 808 297
- DE-A- 19 837 374

## Beschreibung

Die Erfindung betrifft eine elektrische Schaltungsanordnung zur Umformung einer Eingangsspannung in eine eingeprägte elektrische Ausgangsgröße, wobei zwischen Eingangsspannung und Ausgangsgröße eine vorgegebene Zuordnung besteht.

Eine derartige Schaltungsanordnung ist aus der DE 195 47 155 Cl bekannt. Sie ist insbesondere als Sollwertgeber für die Ansteuerung von hydraulischen Stetigventilen mit integrierter Ansteuerelektronik vorgesehen. Die bekannte Schaltungsanordnung formt eine elektrische Eingangsspannung in eine eingeprägte elektrische Ausgangsgröße um. Zwischen der Eingangsspannung und der Ausgangsgröße besteht ein linearer Zusammenhang. Ist der an die Schaltungsanordnung angeschlossene Lastwiderstand kleiner als ein vorgegebener Wert von z. B. 500 Ω, wird die Eingangsspannung in einen Ausgangsstrom umgeformt. Ist der Lastwiderstand dagegen größer als der vorgegebene Wert, wird die Eingangsspannung in eine Ausgangsspannung umgeformt. Ob die elektrische Ausgangsgröße eine Spannung oder ein Strom ist, hängt von der Größe des Lastwiderstands ab. Mit dieser Schaltungsanordnung ist es nicht möglich, die Eingangsspannung unabhängig von der Größe des Lastwiderstandes in einen Ausgangsstrom oder in eine Ausgangsspannung umzuformen.

Der Erfindung liegt die Aufgabe zugrunde, eine elektrische Schaltungsanordnung der eingangs genannten Art zu schaffen, die eine der Schaltungsanordnung zugeführte Eingangsspannung unabhängig von der Größe des Lastwiderstandes wahlweise in einen Ausgangsstrom oder in eine Ausgangsspannung umformt.

Diese Aufgabe wird durch die im Anspruch 1 gekennzeichneten Merkmale gelöst. Die Erfindung ermöglicht es, eine Eingangsspannung in Abhängigkeit von einem der Schaltungsanordnung zugeführten Steuersignal wahlweise in eine Ausgangsspannung oder in einen Ausgangsstrom umzuformen. Bei der Umformung der Eingangsspannung in eine Ausgangsspannung lassen sich unterschiedliche Werte des Verstärkungsfaktors zwischen Eingangsspannung und Ausgangsspannung realisieren. Gleichermaßen lassen sich bei der Umformung der Eingangsspannung in einen Ausgangsstrom unterschiedliche Werte des Verstärkungsfaktors zwischen Eingangsspannung und Ausgangsstrom realisieren.

Vorteilhafte Weiterbildungen der Erfindung sind in den Unteransprüchen gekennzeichnet. Durch additive Überlagerung einer konstanten Spannung zu der Spannung, die ein Maß für die Ausgangsspannung der Schaltungsanordnung ist, läßt sich der Bereich der Ausgangsspannung gegenüber dem Bereich der Eingangsspannung verschieben. Insbesondere läßt sich eine unipolare Eingangsspannung, deren Bereich sich z. B. von 0 V bis -5 V erstreckt, in eine bipolare Ausgangsspannung umformen, deren Bereich z. B. zwischen -10 V und +10 V liegt. Für die Bildung der Gegenkopplungsspannungen sind vorzugsweise Rechenschaltungen vorgesehen. Die Verwendung von als Umschalter ausgebildeten elektronischen Analogschaltern erlaubt eine Ansteuerung der Umschalter mit elektrischen Steuersignalen geringer Leistung. Elektronische Schalter benötigen wenig Platz. Sie weisen eine geringe Störanfälligkeit auf, da sie keine mechanischen Kontakte enthalten, die im Laufe der Zeit verschleißen können oder Übergangswiderstände aufweisen. Im Gegensatz zu elektromagnetischen Relais entfällt bei elektronischen Schaltern die bei bestromter Spule eines Relais auftretende Verlustleistung und die damit verbundene Wärmeentwicklung. Durch eine der zweiten Rechenschaltung zusätzlich zugeführte konstante Spannung wird dafür gesorgt, daß auch dann, wenn die Eingangsspannung in eine Ausgangsspannung umgeformt wird, an den Eingängen des elektronischen Schalters positive Spannungswerte anstehen. In weiteren Unteransprüchen sind vorteilhafte Ausgestaltungen des Reglers und der Rechenschaltungen angegeben. Ein zwischen dem Ausgang des Reglers und dem von dem Ausgangsstrom durchflossenen Widerstand angeordneter Leistungsverstärker ermöglicht es, mit einer geringeren Versorgungsspannung auszukommen, als wenn in dem Regler ein Operationsverstärker mit entsprechend großem Ausgangsstrom verwendet wird.

Die Erfindung wird im folgenden mit ihren weiteren Einzelheiten anhand eines in den Zeichnungen dargestellten Ausführungsbeispiels näher erläutert. Es zeigen
- Figur 1: ein Prinzipschaltbild einer erfindungsgemäßen Schaltungsanordnung und
- Figur 2: ein detaillierteres Schaltbild der in der Figur 1 dargestellten Schaltungsanordnung.

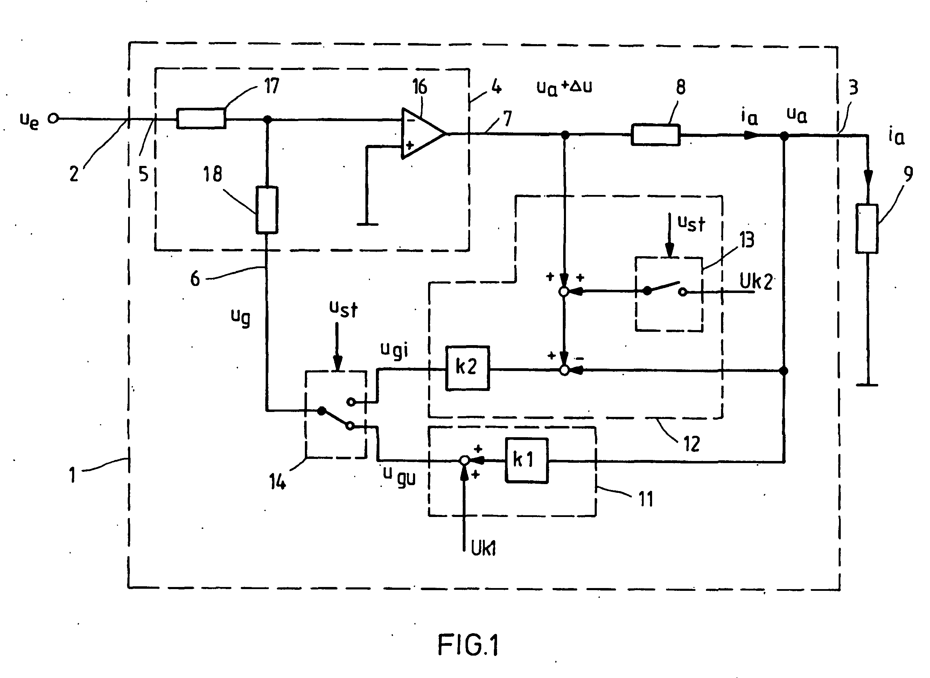

Die Figur 1 zeigt eine elektrische Schaltungsanordnung 1, die eine elektrische Eingangsspannung uₑ in Abhängigkeit von einem mit uₛₜ bezeichneten Steuersignal geringer Leistung wahlweise in eine eingeprägte Ausgangsspannung uₐ oder in einen eingeprägten elektrischen Ausgangsstrom iₐ umformt. Eine derartige Schaltungsanordnung wird insbesondere dann benötigt, wenn die Ausgangsspannung eines Digital/Analog-Wandlers, der das digitale Ausgangssignal eines Mikroprozessors in eine unipolare Spannung umsetzt, in Schaltungsanordnungen weiterverarbeitet wird, die als Eingangsgröße einen Strom benötigen oder eine Spannung, deren Bereich von dem Bereich der Ausgangsgröße des Digital/Analog-Wandlers abweicht.

Eingang.und Ausgang der Schaltungsanordnung 1 sind mit den Bezugszeichen 2 bzw. 3 versehen. Die Schaltungsanordnung 1 enthält einen Regler 4 mit einem Sollwerteingang 5 und einem Istwerteingang 6 sowie einem Ausgang 7. Dem Sollwerteingang 5 des Reglers 4 ist die Eingangsspannung uₑ zugeführt. Eine Gegenkopplungsspannung u_{g}, die ein Maß für die jeweils wirksame elektrische Ausgangsgröße iₐ oder uₐ ist, ist dem Istwerteingang 6 des Reglers 4 zugeführt. Ein Widerstand 8 verbindet den Ausgang 7 des Reglers 4 mit dem Ausgang 3 der Schaltungsanordnung 1. An den Ausgang 3 ist ein weiterer Widerstand 9 angeschlossen. Bei dem Widerstand 9 handelt es sich in der Praxis um den Eingangswiderstand einer nachfolgenden Schaltung, der den Ausgang 3 der Schaltungsanordnung 1 belastet. Der Ausgangsstrom iₐ fließt über die in Reihe geschalteten Widerstände 8 und 9. Die an dem Widerstand 8 abfallende Spannung ist mit Δu bezeichnet, sie ergibt sich zu Δu = iₐ × R8. Dabei ist mit R8 der ohmsche Widerstand des Widerstands 8 bezeichnet.

Eine erste Rechenschaltung 11 bildet aus der Ausgangsspannung uₐ, einem ersten einstellbaren Faktor k1 und einer konstanten Spannung Uₖ₁ eine Spannung u_{gu}. Die Spannung u_{gu} ergibt sich zu u_{gu} = (k1 × uₐ) + Uₖ₁ . Eine zweite Rechenschaltung 12 bildet aus dem Spannungsabfall Δu an dem Widerstand 8 und einem zweiten einstellbaren Faktor k2 eine Spannung u_{gi}. Der Rechenschaltung 12 sind hierzu die Spannung uₐ + Δu an dem einen Anschluß des Widerstands 8 und die Spannung uₐ an dem anderen Anschluß des Widerstands 8 zugeführt. Zusätzlich ist der Rechenschaltung 12 eine konstante Spannung Uₖ₂ zugeführt. Die Spannung Uₖ₂ ist über einen Schalter 13 in Abhängigkeit von dem Steuersignal uₛₜ zuschaltbar. Die Spannung u_{gi} ergibt sich in Abhängigkeit von der Stellung des Schalters 13 zu u_{gi} = k2 × (Δu + Uₖ₂) bzw. u_{gi} = k2 × Δu. Zwischen den Ausgängen der Rechenschaltungen 11 und 12 ist ein Umschalter 14 angeordnet. Der Umschalter 14 verbindet in Abhängigkeit von dem Steuersignal uₛₜ den Ausgang einer der beiden Rechenschaltungen 11 oder 12 mit dem Istwerteingang 6 des Reglers 4.

Um die Eingangsspannung uₑ in eine Ausgangsspannung uₐ umzuformen, wird der Umschalter 14 so angesteuert, daß er den Istwerteingang 6 des Reglers 4 mit dem Ausgang der Rechenschaltung 11 verbindet. In diesem Betriebszustand dient die Ausgangsspannung u_{gu} der Rechenschaltung 11 als Gegenkopplungsspannung u_{g} des Reglers 4. Der Schalter 13 ist in diesem Betriebszustand geschlossen. Der Regler 4 bildet zusammen mit der Rechenschaltung 11 einen Regelkreis für die Ausgangsspannung uₐ. Die Führungsgröße dieses Regelkreises ist die Eingangsspannung uₑ. Die konstante Spannung Uₖ₁ erlaubt die Umformung einer unidirektionalen Eingangsspannung (z. B. im Bereich von 0 V bis -5 V) in eine bidirektionale Ausgangsspannung (z. B. im Bereich von -10 V bis +10 V). Der Ausgangsstrom iₐ der Schaltungsanordnung 1 stellt sich dabei entsprechend dem im folgenden mit R9 bezeichneten ohmschen Widerstand des Lastwiderstands 9 nach der Beziehung iₐ = uₐ/R9 ein.

Um die Eingangsspannung uₑ in einen Ausgangsstrom iₐ umzuformen, wird der Umschalter 14 so angesteuert, daß er den Istwerteingang 6 des Reglers 4 mit dem Ausgang der Rechenschaltung 12 verbindet. In diesem Betriebszustand dient die Ausgangsspannung u_{gi} der Rechenschaltung 12 als Gegenkopplungsspannung u_{g} des Reglers 4. Der Schalter 13 ist in diesem Betriebszustand geöffnet. Der Regler 4 bildet zusammen mit der Rechenschaltung 12 einen Regelkreis für den Ausgangsstrom iₐ. Die Führungsgröße dieses Regelkreises ist die Eingangsspannung uₑ. In diesem Betriebszustand ist es möglich, eine unidirektionale Eingangsspannung (z. B. im Bereich von 0 V bis -5 V) in einen unidirektionalen Ausgangsstrom (z. B. im Bereich von 0 mA bis +20 mA) umzuformen. Die Ausgangsspannung uₐ der Schaltungsanordnung 1 stellt sich dabei entsprechend dem ohmschen Widerstand R9 des Lastwiderstands 9 nach der Beziehung uₐ = iₐ × R9 ein.

Der Regler 4 weist einen Operationsverstärker 16 auf. In der einfachsten Form des Reglers 4 sind dem invertierenden Eingang des Operationsverstärkers 16 über einen Widerstand 17 die Eingangsspannung uₑ und über einen weiteren Widerstand 18 die Gegenkopplungsspannung u_{g} zugeführt und der nichtinvertierende Eingang des Operationsverstärkers 16 ist mit Bezugspotential verbunden.

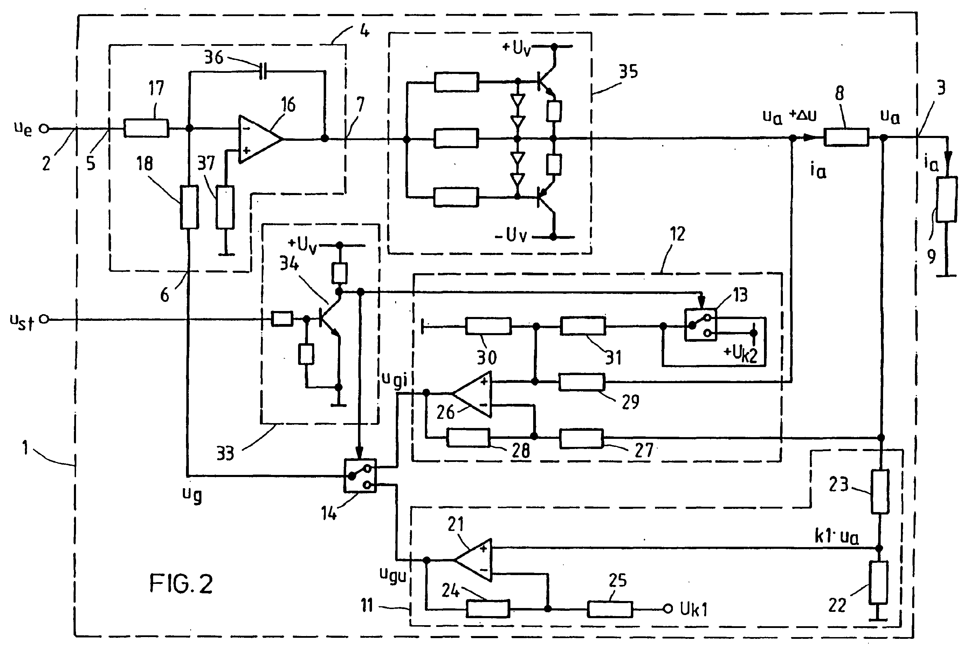

Die Figur 2 zeigt eine detaillierte Darstellung der in der Figur 1 dargestellten erfindungsgemäßen Schaltungsanordnung. Bereits anhand der Figur 1 beschriebene Bauelemente und Baugruppen sind in der Figur 2 mit denselben Bezugszeichen versehen.

Die Rechenschaltung 11 weist einen Operationsverstärker 21 auf. Zwischen dem Ausgang 3 der Schaltungsanordnung 1 und Bezugspotential ist ein aus zwei Widerständen 22 und 23 gebildeter Spannungsteiler angeordnet. Die an dem Widerstand 22 abfallende Teilspannung k1 × uₐ der Ausgangsspannung uₐ ist dem nichtinvertierenden Eingang des Operationsverstärkers 21 zugeführt. Der resultierende Widerstand der Reihenschaltung der Widerstände 22 und 23 ist sehr viel größer gewählt als der Widerstand 9, so daß der über die Widerstände 22 und 23 fließende Strom gegenüber dem über den Widerstand 9 fließenden Strom iₐ vernachlässigbar klein ist. Der Ausgang des Operationsverstärkers 21 ist über einen Widerstand 24 mit seinem invertierenden Eingang verbunden. Zusätzlich ist dem invertierenden Eingang des Operationsverstärkers 21 über einen Widerstand 25 die konstante Spannung Uₖ₁ zugeführt.

Die Rechenschaltung 12 weist einen Operationsverstärker 26 auf. Dem invertierenden Eingang des Operationsverstärkers 26 ist die Ausgangsspannung uₐ über einen Widerstand 27 zugeführt. Der Ausgang des Operationsverstärkers 26 ist über einen Widerstand 28 mit seinem invertierenden Eingang verbunden. Dem nichtinvertierenden Eingang des Operationsverstärkers 26 ist die Spannung uₐ + Δu über einen Widerstand 29 zugeführt. Der nichtinvertierende Eingang des Operationsverstärkers 26 ist zusätzlich über einen Widerstand 30 mit Bezugspotential verbunden. Der Schalter 13 ist - wie der Schalter 14 - als Umschalter ausgebildet. Dem einen Eingang des Schalters 13 ist die konstante Spannung Uₖ₂ zugeführt. Der andere Eingang des Schalters 13 ist mit dem Ausgang des Schalters 13 verbunden. Der Ausgang des Schalters 13 ist über einen Widerstand 31 mit dem nichtinvertierenden Eingang des Operationsverstärkers 26 verbunden.

Das Steuersignal uₛₜ ist einem Schaltverstärker 33 mit einem Schalttransistor 34 zugeführt. Der Schaltverstärker 33 ist an eine positive Versorgungsspannung +Uᵥ angeschlossen. Bei positivem Steuersignal uₛₜ leitet der Schalttransistor 34, den Steuereingängen der Schalter 13 und 14 wird eine Spannung zugeführt, die geringfügig über dem Bezugspotential liegt. Die Schalter 13 und 14 befinden sich in der in der Figur 2 dargestellten Lage, d. h. der Istwerteingang 6 des Reglers 4 ist mit dem Ausgang der Rechenschaltung 12 verbunden und der Ausgang des Schalters 13 ist direkt mit einem seiner Eingänge verbunden. Die Eingangsspannung uₑ wird in diesem Betriebszustand in einen eingeprägten Strom umgeformt. Liegt das Steuersignal uₛₜ auf Bezugspotential, ist der Schalttransistor 34 gesperrt und den Steuereingängen der Schalter 12 und 13 wird die Versorgungsspannung +Uᵥ zugeführt. Der Istwerteingang 6 des Reglers 4 ist mit dem Ausgang der Rechenschaltung 11 verbunden und der Widerstand 31 ist mit der konstanten Spannung Uₖ₂ beaufschlagt. In diesem Betriebszustand wird die Eingangsspannung uₑ in eine eingeprägte Spannung umgeformt.

Zwischen dem Ausgang 7 des Reglers 4 und dem Widerstand 8 ist eine Leistungsstufe 35 angeordnet, die von der positiven Versorgungsspannung +Uᵥ und einer negativen Versorgungsspannung -Uᵥ versorgt wird. Die Leistungsstufe 35 ermöglicht es, für den Regler 4 einen Operationsverstärker 16 mit nur geringem Ausgangsstrom zu verwenden. Außerdem reichen beim Einsatz der Leistungsstufe 35 geringere Versorgungsspannungen aus, als beim Einsatz eines Operationsverstärkers mit entsprechendem Ausgangsstrom im Regler erforderlich wären. Obwohl bei der Umformung der Eingangsspannung uₑ in den Ausgangsstrom iₐ nur ein Stromfluß von der Leistungsstufe 35 zu dem Ausgang 3 der Schaltungsanordnung 1 erfolgt, ist die Leistungsstufe 35 symmetrisch aufgebaut, da bei der Umformung der Eingangsspannung uₑ in eine bidirektionale Ausgangsspannung uₐ bei negativer Polarität der Ausgangsspannung uₐ auch ein Stromfluß von dem Ausgang 3 der Schaltungsanordnung 1 zu dem Leistungsverstärker 35 erfolgt.

Zwischen dem Ausgang des Operationsverstärkers 16 und seinem invertierenden Eingang ist ein Kondensator 36 angeordnet. Der Kondensator 36 verleiht dem Regler 4 I-Verhalten. Zwischen dem nichtinvertierenden Eingang des Operationsverstärkers 16 und dem Bezugspotential ist ein Widerstand 37 angeordnet. Sein ohmscher Widerstand entspricht der Parallelschaltung der Widerstände 17 und 18. Der Widerstand 37 dient zur Offsetkorrektur des Operationsverstärkers 16.

Die Schalter 13 und 14 sind elektronische Analogschalter, die von einem digitalen Steuersignal geringer Leistung angesteuert werden. In dem von der Firma National Semiconductor unter der Bezeichnung CD4053BM/CD4053BC vertriebenen Bauelement sind drei derartige Umschalter in einem gemeinsamen Gehäuse zusammengefaßt. Ein derartiges Bauelement benötigt wenig Platz auf der Schaltungsplatine. Außerdem ist die Wärmeentwicklung eines derartigen Bauteils praktisch zu vernachlässigen. Andererseits ist jedoch zu beachten, daß die Eingänge dieser elektronischen Umschalter nur mit positiven Spannungen beaufschlagt werden dürfen. Den Umschaltern 13 und 14 sind jeweils eine digitale Spannung, die als Steuersignal dient, und zwei analoge Spannungen, von denen jeweils eine an den Ausgang des Umschalters weitergeleitet wird, zugeführt. Wie oben beschrieben, werden die Steuereingänge der Schalter 13 und 14 von dem Schaltverstärker 33 mit einer positiven Spannung beaufschlagt, die in dem einen Betriebszustand praktisch gleich der positiven Versorgungsspannung +Uᵥ und in dem anderen Betriebszustand geringfügig größer als das Bezugspotential ist. Damit ist sichergestellt, daß dem Steuereingang der Umschalter 13 und 14 in beiden Betriebszuständen eine positive Spannung zugeführt ist.

Durch die im folgenden beschriebenen Maßnahmen ist sichergestellt, daß auch die den Signaleingängen der Umschalter 13 und 14 zugeführten analogen Spannungen in beiden Betriebszuständen positiv sind. Wenn die Eingangsspannung uₑ in dem einen Betriebszustand in einen eingeprägten unipolaren Strom umgeformt wird, ist die Polarität der Ausgangsspannung uₐ positiv, da der Ausgangsstrom iₐ von dem Ausgang 3 der Schaltungsanordnung 1 über den Widerstand 9 zum Bezugspotential fließt. Wenn die Eingangsspannung uₑ in dem anderen Betriebszustand in eine eingeprägte bipolare Ausgangsspannung umgeformt wird, ist die Ausgangsspannung uₐ in einem ersten Bereich positiv und in einem zweiten Bereich negativ. Die konstante Spannung Uₖ₁ ist daher so zu wählen, daß sich unter Berücksichtigung der Größe der Widerstände 22, 23 24 und 25 für die Spannung u_{gu} stets ein positiver Wert ergibt. Die Widerstände 24 und 25 bilden einen Spannungsteiler, dessen Enden mit der Spannung u_{gu} und mit der Spannung Uₖ₁ beaufschlagt sind und dessen Abgriff mit dem invertierenden Eingang des Operationsverstärkers 21 verbunden ist. Die Spannung u_{gu} stellt sich daher so ein, daß die Spannung am Verbindungspunkt der Widerstände 24 und 25 gleich der Spannung am Verbindungspunkt der Widerstände 22 und 23, d. h. k1 × uₐ, ist. Wählt man z. B. den Widerstand 25 doppelt so groß wie den Widerstand 24 und den Faktor k1 = 1/6, ergibt sich die Spannung u_{gu} zu u_{gu} = 0,25 × uₐ - 0,5 × Uₖ₁. Damit die Spannung u_{gu} für einen Bereich der Ausgangsspannung von z. B. -10 V bis +10 V positiv ist, ist die konstante Spannung Uₖ₁ zu Uₖ₁ = -5 V zu wählen. Damit ergeben sich für die Spannung u_{gu} Werte von 0 V bis +5 V und für die Eingangsspannung uₑ ein Bereich von 0 V bis -5 V. Für alle Werte der Ausgangsspannung uₐ, die größer als -10 V sind, ist die dem Umschalter 14 zugeführte Spannung u_{gu} somit - wie gefordert - positiv.

Wie im folgenden beschrieben, ist auch die Spannung u_{gi} in beiden Betriebszuständen positiv. Bei der Umformung der Eingangsspannung uₑ in einen eingeprägten Strom befindet sich der Umschalter 13 in der in der Figur 2 dargestellten Stellung, d. h. der Ausgang des Umschalters 13 ist mit dem einem Eingang verbunden und der andere Eingang ist mit der Spannung Uₖ₂ beaufschlagt. Bei der Spannung Uₖ₂ handelt es sich um eine positive Spannung, z. B. um die positive Versorgungsspannung +Uᵥ. Der eingeprägte Strom iₐ fließt von dem Ausgang des Leistungsverstärkers 35 über die Widerstände 8 und 9 zum Bezugspotential. Die Widerstände 30 und 29 bilden einen Spannungsteiler, dem die Spannung uₐ + Δu zugeführt ist und dessen Abgriff mit dem nichtinvertierenden Eingang des Operationsverstärkers 26 verbunden ist. Wählt man z. B. den Widerstand 30 zehn Mal so groß wie den Widerstand 29, so ist die dem nichtinvertierenden Eingang des Operationsverstärkers 26 zugeführte Spannung 10/11 × (uₐ + Δu). Da die Spannung uₐ in diesem Betriebszustand - wie oben ausgeführt - nur positive Werte annimmt und da über den Widerstand 31 kein Strom fließt, steht an dem mit dem Ausgang des Umschalters 13 verbundenen Eingang - wie gefordert - eine positive Spannung an. Die Widerstände 27 und 28 bilden einen Spannungsteiler, dessen Enden mit den Spannungen u_{gi} und uₐ beaufschlagt sind und dessen Abgriff mit dem invertierenden Eingang des Operationsverstärkers 26 verbunden ist. Die Spannung u_{gi} stellt sich so ein, daß die Spannung an dem invertierenden Eingang des Operationsverstärkers 26 gleich der dem nichtinvertierenden Eingang zugeführten Spannung, d. h. 10/11 × (uₐ + Δu), ist. Wählt man den Widerstand 28 zehn Mal so groß wie den Widerstand 27, ergibt sich die Spannung u_{gi} zu u_{gi} = 10 × Δu. Die Spannung u_{gi} ist dabei unabhängig von der Höhe der Ausgangsspannung uₐ. Da die Spannung Δu bei der Umformung der Eingangsspannung uₑ in einen eingeprägten Strom positiv ist, ist die dem Umschalter 14 in diesem Betriebszustand zugeführte Spannung u_{gi} ebenfalls positiv. Soll der Ausgangsstrom bei einer Eingangsspannung uₑ von 0 V bis -5 V zwischen 0 mA und 20 mA betragen, muß an dem Widerstand 8 eine Spannung Δu von 0 V bis 0,5 V abfallen. Daraus ergibt sich für den Widerstand 8 ein Widerstandswert von R8 = 25 Ω.

Bei der Umformung der Eingangsspannung uₑ in eine eingeprägte Spannung verbindet der Umschalter 14 den Ausgang des Operationsverstärkers 21 mit dem Istwerteingang 6 des Reglers 4. Der Regelkreis ist über die Rechenschaltung 11 geschlossen, die Rechenschaltung 12 ist ausgangsseitig offen. Der Umschalter 13 verbindet jetzt den Widerstand 31 mit der Spannung Uₖ₂. Von dem Ausgang des Umschalters 13 ist die Spannung Uₖ₂ auf den anderen Eingang des Umschalters 13 zurückgeführt. Damit sind beide Signaleingänge des Umschalters 13 - wie gefordert - mit einer positiven Spannung beaufschlagt. Wählt man den Widerstand 31 gleich groß wie den Widerstand 29, kann man die Widerstände 29 und 31 als einen Spannungsteiler betrachten, dessen Enden die Spannung Uₖ₂ und die Spannung uₐ + Δu zugeführt sind. An dem Abgriff dieses Spannungsteilers steht dann eine Spannung an, die um die halbe Differenz der ihm zugeführten Spannungen kleiner als die größere dieser Spannungen ist. Die Spannung Uₖ₂ ist so gewählt, daß auch im ungünstigsten Fall, d. h. bei negativen Werten der Ausgangsspannung uₐ, dem nichtinvertierenden Eingang des Operationsverstärkers 26 eine positive Spannung zugeführt ist. Da der Widerstand 30 zehn mal größer als die Widerstände 29 und 31 ist, ist sein Einfluß auf die dem nichtinvertierenden Eingang des Operationsverstärkers 26 zugeführte Spannung bei der hier durchgeführten qualitativen Betrachtung vernachlässigbar. Da - wie oben ausgeführt - der Widerstand 28 zehn Mal größer als der Widerstand 27 ist, ist dem invertierenden Eingang des Operationsverstärkers 26 eine Spannung zugeführt, die um 10/11 der Differenz zwischen der Spannung u_{gi} und der Spannung uₐ kleiner als die Spannung u_{gi} ist. Da diese Spannung wegen der auf die positive Versorgungsspannung +Uᵥ begrenzten Ausgangsspannung des Operationsverstärkers 26 kleiner als die dem nichtinvertierenden Eingang zugeführte Spannung ist, ist die Ausgangsspannung des Operationsverstärkers 26 und damit die Spannung u_{gi} praktisch gleich der positiven Versorgungsspannung +Uᵥ. Somit ist die Spannung u_{gi} - wie gefordert - positiv. Da die Spannung u_{gi} in diesem Betriebszustand nicht an den Regler 4 weitergeleitet wird, spielt ihre Höhe keine Rolle. Wie allgemein üblich, sind die Umschalter 13 und 14 so ausgewählt, daß die maximal zulässigen Spannungen größer als die in der Schaltungsanordnung 1 auftretenden Spannungen sind.

## Patentansprüche

1. Elektrische Schaltungsanordnung zur Umformung einer Eingangsspannung in eine eingeprägte elektrische Ausgangsgröße, wobei zwischen Eingangsspannung und Ausgangsgröße eine vorgegebene Zuordnung besteht, **dadurch gekennzeichnet,**
- **daß** dem Sollwerteingang (5) eines Reglers (4) die Eingangsspannung (uₑ) zugeführt ist,
- **daß** dem Istwerteingang (6) des Reglers (4) eine Gegenkopplungsspannung (u_{g}) zugeführt ist, die ein Maß für die jeweils wirksame Ausgangsgröße (uₐ, iₐ) der Schaltungsanordnung ist,
- **daß** für eine Umformung der Eingangsspannung (uₑ) in eine Ausgangsspannung (uₐ) die Gegenkopplungsspannung (u_{gu}) eine erste, der Ausgangsspannung (uₐ) proportionale Spannung (k1 × uₐ) ist und
- **daß** für eine Umformung der Eingangsspannung (uₑ) in einen Ausgangsstrom (iₐ) die Gegenkopplungsspannung (u_{gi}) eine zweite Spannung (k2 × Δu) ist, die proportional zu einer an einem von dem Ausgangsstrom (iₐ) durchflossenen Widerstand (8) der Schaltungsanordnung (1) abfallenden Spannung (Δu = iₐ × R8) ist.

2. Schaltungsanordnung nach Anspruch 1, **dadurch gekennzeichnet, daß** für die Umformung der Eingangsspannung (uₑ) in eine Ausgangsspannung (uₐ) die Gegenkopplungsspannung (u_{gu}) die Summe aus der der Ausgangsspannung (uₐ) proportionalen Spannung (k1 × uₐ) und einer konstanten Spannung (Uₖ₁) ist.

3. Schaltungsanordnung nach Anspruch 2, **dadurch gekennzeichnet,**
- **daß** einer ersten Rechenschaltung (11) die Ausgangsspannung (uₐ) und die konstante Spannung (Uₖ₁) zugeführt sind,
- **daß** einer zweiten Rechenschaltung (12) die Spannung (uₐ + Δu) an dem einen Anschluß des Widerstands (8) und die Spannung (uₐ) an dem anderen Anschluß des Widerstands (8) zugeführt sind, und
- **daß** zwischen den Ausgängen der beiden Rechenschaltungen (11, 12) und dem Istwerteingang (6) des Reglers (4) ein steuerbarer Schalter (14) angeordnet ist, der den Ausgang einer der beiden Rechenschaltungen (11, 12) mit dem Istwerteingang des Reglers (4) verbindet.

4. Schaltungsanordnung nach Anspruch 3, **dadurch gekennzeichnet, daß** der Schalter (14) ein als Umschalter ausgebildeter, durch ein Steuersignal (uₛₜ) steuerbarer elektronischer Analogschalter ist.

5. Schaltungsanordnung nach Anspruch 4, **dadurch gekennzeichnet, daß** bei der Umformung der Eingangsspannung (uₑ) in eine Ausgangsspannung (uₐ) eine zweite konstante Spannung (Uₖ₂) mit den anderen der zweiten Rechenschaltung (12) zugeführten Spannungen (uₐ + Δu, uₐ) im Sinne einer Vergrößerung der dem Schalter (14) zugeführten Spannung (u_{gi}) verknüpft ist.

6. Schaltungsanordnung nach einem der vorhergehenden Ansprüche, **dadurch gekennzeichnet, daß** der Regler (4) einen Operationsverstärker (16) aufweist, dessen invertierendem Eingang die Eingangsspannung (uₑ) über einen zweiten Widerstand (17) und die Gegenkopplungsspannung (u_{g}) über einen dritten Widerstand (18) zugeführt sind und dessen nichtinvertierender Eingang mit Bezugspotential (⊥) verbunden ist.

7. Schaltungsanordnung nach einem der Ansprüche 3 bis 6, **dadurch gekennzeichnet,**
- **daß** die erste Rechenschaltung (11) einen zweiten Operationsverstärker (21) aufweist,
- **daß** dem nichtinvertierenden Eingang des zweiten Operationsverstärkers (21) eine an einem mit der Ausgangsspannung (uₐ) beaufschlagten Spannungsteiler (22, 23) abgegriffene Teilspannung (k1 × uₐ) zugeführt ist,
- **daß** dem invertierenden Eingang des zweiten Operationsverstärkers (21) die erste konstante Spannung (Uₖ₁) über einen vierten Widerstand (25) zugeführt ist und
- **daß** der Ausgang des zweiten Operationsverstärkers (21) über einen fünften Widerstand (24) mit seinem invertierenden Eingang verbunden ist.

8. Schaltungsanordnung nach einem der Ansprüche 3 bis 7, **dadurch gekennzeichnet,**
- **daß** die zweite Rechenschaltung (12) einen dritten Operationsverstärker (26) aufweist,
- **daß** dem invertierenden Eingang des dritten Operationsverstärkers (26) über einen sechsten Widerstand (27) die Ausgangsspannung (uₐ) zugeführt ist,
- **daß** der Ausgang des dritten Operationsverstärkers (26) über einen siebten Widerstand (28) mit seinem invertierenden Eingang verbunden ist,
- **daß** dem nichtinvertierenden Eingang des dritten Operationsverstärkers (26) über einen achten Widerstand (29) die um die an dem ersten Widerstand (8) abfallende Spannung (Δu) erhöhte Ausgangsspannung (uₐ) zugeführt ist und
- **daß** der nichtinvertierende Eingang des dritten Operationsverstärkers (26) über einen neunten Widerstand (30) mit Bezugspotential (⊥) verbunden ist.

9. Schaltungsanordnung nach Anspruch 8, **dadurch gekennzeichnet, daß** die zweite konstante Spannung (Uₖ₂) dem nichtinvertierenden Eingang des dritten Operationsverstärkers (26) über einen zweiten Schalter (13) und einen zehnten Widerstand (31) zugeführt ist.

10. Schaltungsanordnung nach Anspruch 9, **dadurch gekennzeichnet,**
- **daß** der zweite Schalter (13) ein durch das Steuersignal (uₛₜ) steuerbarer elektronischer Umschalter ist,
- **daß** der Ausgang des zweiten Schalters (13) mit seinem einen Eingang verbunden ist und
- **daß** dem anderen Eingang des zweiten Schalters (13) die zweite konstante Spannung (Uₖ₂) zugeführt ist.

11. Schaltungsanordnung nach einem der vorhergehenden Ansprüche, **dadurch gekennzeichnet, daß** zwischen dem Ausgang (7) des Reglers (4) und dem ersten Widerstand (8) eine Leistungsstufe (35) angeordnet ist.

12. Schaltungsanordnung nach Anspruch 6 oder nach einem der Ansprüche 7 bis 11, soweit dieser alle Merkmale des Anspruchs 6 beinhaltet, **dadurch gekennzeichnet, daß** zwischen dem Ausgang des ersten Operationsverstärkers (16) und seinem invertierenden Eingang ein Kondensator (36) angeordnet ist.

13. Schaltungsanordnung nach Anspruch 6 oder nach einem der Ansprüche 7 bis 12, soweit dieser alle Merkmale des Anspruchs 6 beinhaltet, **dadurch gekennzeichnet, daß** zwischen dem nichtinvertierenden Eingang des ersten Operationsverstärkers (16) und Bezugspotential (⊥) ein elfter Widerstand (37) angeordnet ist, dessen Größe der Parallelschaltung des zweiten Widerstands (17) und des dritten Widerstands (18) entspricht.

## Claims

1. An electrical circuit arrangement for converting an input voltage into an impressed electrical output variable, there being a predetermined assignment between input voltage and output variable, **characterized by the fact**
- that the input voltage (uₑ) is fed to the desired value input (5) of a controller (4),
- that a negative feedback voltage (u_{g}) is fed to the actual value input (6) of the controller (3), said voltage being a measure of the respectively effective output variable (uₐ, iₐ) of the circuit arrangement,
- that, for converting the input voltage (uₑ) into an output voltage (uₐ), the negative feedback voltage (u_{gu}) is a voltage (k1 x uₐ) proportional to the output voltage (uₐ), and
- that, for converting the input voltage (uₑ) into an output current (iₐ) the negative feedback voltage (u_{gi}) is a voltage (k2 x Δu) which is proportional to a voltage (Δu = iₐ x R8) dropped across a resistor (8) through which the output current (iₐ) flows.

2. A circuit arrangement according to claim 1, **characterized by the fact** that, for converting the input voltage (uₑ) into an output voltage (uₐ), the negative feedback voltage (u_{gu}) is the sum of the voltage (k1 x uₐ) proportional to the output voltage (uₐ) and a constant voltage (Uₖ₁)

3. A circuit arrangement according to claim 2, **characterized by the fact**
- that the output voltage (uₐ) and the constant voltage (Uₖ₁) are fed to a first computing circuit (11),
- that the voltage (uₐ + Δu) at one terminal of the resistor (8) and the voltage (uₐ) at the other terminal of the resistor (8) are fed to a second computing circuit (12) and
- that a controllable switch (14) is arranged between the outputs of the two computing circuits (11, 12) and the actual value input (6) of the controller (4), which switch connects the output of one of the two computing circuits (11, 12) to the actual value input of the controller (4).

4. A circuit arrangement according to claim 3, **characterized by the fact** that the switch (14) is an electronic analogue switch which is formed as a changeover switch and can be controlled by a control signal (uₛₜ).

5. A circuit arrangement according to claim 4, **characterized by the fact** that, during the conversion of the input voltage (uₑ) into an output voltage (uₐ), a second constant voltage (Uₖ₂) is combined with the other voltages (uₐ + Δu, uₐ), fed to the second computing circuit (12), with the aim of increasing the voltage (u_{gi}) fed to the switch (14).

6. A circuit arrangement according to any of the preceding claims, **characterized by the fact** that the controller (4) has an operational amplifier (16), to whose inverting input the input voltage (uₑ) is fed via a second resistor (17) and the negative feedback voltage (u_{g}) is fed via a third resistor (18) and whose noninverting input is connected to reference potential (⊥).

7. A circuit arrangement according to any of claims 3 to 6, **characterized by the fact**
- that the first computing circuit (11) has a second operational amplifier (21),
- that a partial voltage (k1 x uₐ) tapped off at a voltage divider (22, 23) to which the output voltage (uₐ) is applied is fed to the noninverting input of the second operational amplifier (21),
- that the first constant voltage (Uₖ₁) is fed to the inverting input of the second operational amplifier (21) via a fourth resistor (25), and
- that the output of the second operational amplifier (21) is connected to its inverting input via a fifth resistor (24).

8. A circuit arrangement according to any of claims 3 to 7, **characterized by the fact**
- that the second computing circuit (12) has a third operational amplifier (26),
- that the output voltage (uₐ) is fed to the inverting input of the third operational amplifier (26) via a sixth resistor (27),
- that the output of the third operational amplifier (26) is connected to its inverting input via a seventh resistor (28),
- that the output voltage (uₐ) increased by the voltage (Δu) dropped across the first resistor (8) is fed to the noninverting input of the third operational amplifier (26) via an eighth resistor (29), and
- that the noninverting input of the third operational amplifier (26) is connected to reference potential (⊥) via a ninth resistor (30).

9. A circuit arrangement according to claim 8, **characterized by the fact** that the second constant voltage (Uₖ₂) is fed to the noninverting input of the third operational amplifier (26) via a second switch (13) and a tenth resistor (31).

10. A circuit arrangement according to claim 9, **characterized by the fact**
- that the second switch (13) is an electronic changeover switch which can be controlled by the control signal (uₛₜ)
- that the output of the second switch (13) is connected to one of its inputs, and
- that the second constant voltage (Uₖ₂) is fed to the other input of the second switch (13).

11. A circuit arrangement according to any of the preceding claims, **characterized by the fact** that a power output stage (35) is arranged between the output (7) of the controller (4) and the first resistor (8).

12. A circuit arrangement according to claim 6 or any of claims 7 to 11, insofar as it encompasses all of the features of claim 6, **characterized by the fact** that a capacitor (36) is arranged between the output of the first operational amplifier (16) and its inverting input.

13. A circuit arrangement according to claim 6 or any of claims 7 to 12, insofar as it encompasses all of the features of claim 6, **characterized by the fact** that an eleventh resistor (37) is arranged between the noninverting input of the first operational amplifier (16) and reference potential (⊥), the value of which resistor corresponds to the parallel circuit formed by the second resistor (17) and the third resistor (18).

## Revendications

1. Un dispositif de commutation électrique destiné à transformer une tension d'entrée en une valeur de sortie électrique appliquée, cependant qu'une correspondance donnée est respectée entre la tension d'entrée et la valeur de sortie, **caractérisé en ce**
- **que** la tension (uₑ) d'entrée est ramenée à l'entrée (5) de consigne d'un régulateur (4),
- **qu**'une tension (u_{g}) de contre-réaction est ramenée à l'entrée (6) de valeur réelle du régulateur (4) et constitue une mesure de la valeur (uₐ, iₐ) de sortie active à un instant donné du dispositif de commutation,
- **que,** pour transformer la tension (uₑ) d'entrée en une tension (uₐ) de sortie, la tension (u_{gu}) de contre-réaction est une première tension (k1 x uₐ), proportionnelle à la tension (uₐ) de sortie, et
- **que,** pour transformer la tension (uₑ) d'entrée en un courant (iₐ) de sortie, la tension (u_{gi}) de contre-réaction est une deuxième tension (k2 x Δu), qui est proportionnelle à une chute de tension (Δu = iₐ x R8) régnant sur une résistance (8) du dispositif (1) de commutation parcourue par le courant (iₐ) de sortie.

2. Un dispositif de commutation selon la revendication n° 1, **caractérisé en ce que** pour la transformation de la tension (uₑ) d'entrée en une tension (uₐ) de sortie, la tension (u_{gu}) de contre-réaction est la somme de la tension (k1 x uₐ), proportionnelle à la tension (uₐ) de sortie, et d'une tension (Uₖ₁) constante.

3. Un dispositif de commutation selon la revendication n° 2, **caractérisé en ce**
- **que** la tension (uₐ) de sortie et la tension (Uₖ₁) constante sont ramenées à un premier branchement (11) de calcul,
- **que** la tension (uₐ + Δu) régnant à l'une des bornes de la résistance (8) et la tension (uₐ) régnant à l'autre borne de la résistance (8) sont ramenées à un deuxième branchement (12) de calcul et
- **qu**'entre les sorties des deux branchements (11, 12) de calcul et l'entrée (6) de valeur réelle du régulateur (4) est disposé un commutateur (14) pilotable, qui relie la sortie de l'un des deux branchements (11, 12) de calcul à l'entrée de valeur réelle du régulateur (4).

4. Un dispositif de commutation selon la revendication n° 3, **caractérisé en ce que** le commutateur (14) est un commutateur électronique analogue pouvant être piloté par un signal (uₛₜ) de commande et conçu sous forme de répartiteur.

5. Un dispositif de commutation selon la revendication n° 4, **caractérisé en ce que** lors de la transformation de la tension (uₑ) d'entrée en une tension (uₐ) de sortie, une deuxième tension (Uₖ₂) constante est combinée avec les autres tensions (uₐ + Δu, uₐ) ramenées au deuxième branchement (12) de calcul, dans le sens d'une augmentation de la tension (u_{gi}) ramenée au commutateur (14).

6. Un dispositif de commutation selon une des revendications précédentes, **caractérisé en ce que** le régulateur (4) présente un amplificateur (16) opérationnel, dont l'entrée inverseuse est alimentée par la tension (uₑ) d'entrée en passant par une deuxième résistance (17) et par la tension (u_{g}) de contre-réaction en passant par une troisième résistance (18) et dont l'entrée non-inverseuse est reliée au potentiel (⊥) de référence.

7. Un dispositif de commutation selon une des revendications n° 3 à n° 6, **caractérisé en ce**
- **que** le premier branchement (11) de calcul présente un deuxième amplificateur (21) opérationnel,
- **que** l'entrée non-inverseuse du' deuxième amplificateur (21) opérationnel est alimentée par une tension partielle (k1 x uₐ), saisie par un diviseur (22, 23) de tension soumis à la tension (uₐ) de sortie,
- **que** l'entrée inverseuse du deuxième amplificateur (21) opérationnel est alimentée par la première tension (Uₖ₁) constante en passant par une quatrième résistance (25) et
- **que** la sortie du deuxième amplificateur (21) opérationnel est reliée à son entrée inverseuse par une cinquième résistance (24).

8. Un dispositif de commutation selon une des revendications n° 3 à n° 7, **caractérisé en ce**
- **que** le deuxième branchement (12) de calcul présente un troisième amplificateur (26) opérationnel,
- **que** l'entrée inverseuse du troisième amplificateur (26) opérationnel est alimentée par la tension (uₐ) de sortie en passant par une sixième résistance (27),
- **que** la sortie du troisième amplificateur (26) opérationnel est reliée à son entrée inverseuse en passant par une septième résistance (28),
- **que** l'entrée non-inverseuse du troisième amplificateur (26) opérationnel est alimentée par la tension de sortie (uₐ) augmentée de la chute (Δu) de tension régnant sur la première résistance (8) en passant par une huitième résistance (29) et
- **que** l'entrée non-inverseuse du troisième amplificateur (26) opérationnel est reliée au potentiel (⊥) de référence en passant par une neuvième résistance (30).

9. Un dispositif de commutation selon la revendication n° 8, **caractérisé en ce que** la deuxième tension (Uₖ₂) constante est ramenée vers l'entrée non-inverseuse du troisième amplificateur (26) opérationnel en passant par un deuxième commutateur (13) et une dixième résistance (31).

10. Un dispositif de commutation selon la revendication n° 9, **caractérisé en ce**
- **que** le deuxième commutateur (13) est un répartiteur de courant électronique pouvant être piloté par le signal (uₛₜ) de commande,
- **que** la sortie du deuxième commutateur (13) est reliée à l'une de ses entrées et
- **que** l'autre entrée du deuxième commutateur (13) est alimentée par la deuxième tension (Uₖ₂) constante.

11. Un dispositif de commutation selon une des revendications précédentes, **caractérisé en ce qu'**un étage de puissance (35) est disposée entre la sortie (7) du régulateur (4) et la troisième résistance (8).

12. Un dispositif de commutation selon la revendication n° 6 ou selon une des revendications n° 7 à n° 11, dans la mesure où elle comporte toutes les caractéristiques de la revendication n° 6, **caractérisé en ce qu'**un condensateur (36) est disposé entre la sortie du premier amplificateur (16) opérationnel et son entrée inverseuse.

13. Un dispositif de commutation selon la revendication n° 6 ou selon une des revendications n° 7 à n° 12, dans la mesure où elle comporte toutes les caractéristiques de la revendication n° 6, **caractérisé en ce qu'**entre l'entrée non-inverseuse du premier amplificateur (16) opérationnel et le potentiel (⊥) de référence est disposée une onzième résistance (37), dont le calibre correspond au branchement en parallèle de la deuxième résistance (17) et de la troisième résistance (18).
